# EUROPÄISCHE PATENTSCHRIFT

(11) **EP 0 948 820 B1**
(45) Veröffentlichungstag und Bekanntmachung des Hinweises auf die Patenterteilung: **16.10.2002**
(21) Anmeldenummer: 97950204.4
(22) Anmeldetag: 19.11.1997
(51) Int. Cl.: H01L 31/0236, H01L 31/0224

(54) **SOLARZELLE MIT GERINGER ABSCHATTUNG UND VERFAHREN ZUR HERSTELLUNG**
SOLAR CELL WITH REDUCED SHADING AND METHOD OF PRODUCING THE SAME
PILE SOLAIRE A FAIBLE OMBRAGE ET SON PROCEDE DE PRODUCTION

(30) Priorität: 03.12.1996 DE 19650111
(43) Veröffentlichungstag der Anmeldung: 13.10.1999
(73) Patentinhaber: Shell Solar GmbH, 80807 München (DE)
(72) Erfinder: ENDRÖS, Arthur, D-80337 München (DE)
(74) Vertreter: Zeestraten, Albertus Wilhelmus Joannes
(86) Internationale Anmeldenummer: EP9706465
(87) Internationale Veröffentlichungsnummer: WO98025312

(56) Entgegenhaltungen:
- US-A- 5 067 985
- MARTINELLI G ET AL: "GROWTH OF STABLE DISLOCATION-FREE 3-GRAIN SILICON INGOTS FOR THINNER SLICING" APPLIED PHYSICS LETTERS, Bd. 62, Nr. 25, 21.Juni 1993, Seiten 3262-3263, XP000380976
- GEE J M ET AL: "EMITTER WRAP-THROUGH SOLAR CELL" PROCEEDINGS OF THE PHOTOVOLTAIC SPECIALISTS CONFERENCE, LOUISVILLE, MAY 10 - 14, 1993, Nr. CONF. 23, 10.Mai 1993, INSTITUTE OF ELECTRICAL AND ELECTRONICS ENGINEERS, Seiten 265-270, XP000437966

## Beschreibung

Eine geringe Abschattung kann zum Beispiel in einer Solarzelle realisiert werden, bei der sich sowohl die n- als auch die p-Kontakte auf der Rückseite befinden. Auf diese Weise wird die Vorderseite durch keinen Kontakt abgeschattet und steht daher uneingeschränkt zur Lichteinstrahlung zur Verfügung.

Eine Solarzelle ohne Vorderseitenmetallisierung ist beispielsweise aus R. A. Sinton, P. J. Verlinden, R. A. Crane, R. M. Swanson, C. Tilford, J. Perkins and K. Garrison, "Large-Area 21 % Efficient Si Solar Cells", Proc. of the 23rd IEEE Photovoltaic Specialists Conference, Louisville, 1993, Seiten 157 bis 161 bekannt. Zu deren Herstellung werden in mehreren Maskenschritten unterschiedlich dotierte Gebiete nebeneinander erzeugt und durch Darüberaufbringen einer mehrschichtigen Metallstruktur metallisiert bzw. kontaktiert. Das Aufbringen der Metallstrukturen erfolgt dabei durch Dünnschichtverfahren.

Nachteilig ist dabei, daß das Verfahren mehrere Maskenschritte benötigt und dadurch aufwendig ist. Außerdem müssen sämtliche Ladungsträger durch Diffusion zur Rückseite der Solarzelle gelangen, wobei eine erhöhte Wahrscheinlichkeit der Ladungsträgerrekombination besteht, die den Sammelwirkungsgrad der Solarzelle wieder reduziert.

Ein weiteres Konzept einer Solarzelle ohne Vorderseitenmetallisierung ist aus dem Artikel "Emitter Wrap-Through Solar Cell" von James M. Gee et al in einem Beitrag zur 23^{rd} Photovoltaic Specialists Conference 1993, Louisville, Seiten 265 bis 270, bekannt. Die dort beschriebene Solarzelle weist eine in der Nähe der Vorderseite gelegene Emitterschicht mit daran angrenzendem pn-Übergang auf. Mit einem Laser gebohrte und Metallisierte Kontaktlöcher verbinden die Emitterschicht mit auf der Rückseite gelegenen metallisierten Kontakten. Die Rückseitenkontakte sind interdigital zu den "Vorderseitenkontakten" ebenfalls auf der Rückseite angeordnet. Nachteilig an dieser Solarzelle ist die hohe Anzahl der mit einem Laser zu bohrenden Kontaktlöcher die für eine typische 100 cm² große Solarzelle und einem typischen Kontaktlochabstand von 1 mm ca. 10.000 Kontaktlöcher pro Solarzelle erfordert. Dies reduziert den Durchsatz in einer automatisierten Fertigung. Zusätzlich müssen die Kontaktlöcher und die dazugehörigen auf der Rückseite angeordneten Kontakte zueinander justiert werden. Außerdem kann es in den mit einem Laser gebohrten Kontaktlöchern zu unerwünschten Strukturumwandlungen im Silizium kommen, womit zusätzliche Rekombinationszentren für Ladungsträgerpaare geschaffen werden können, die den Sammelwirkungsgrad weiter reduzieren. Die reduzierte mechanische Festigkeit kann bei diesen Solarzellen zum Bruch führen.

Aus der US 5,067,985 ist eine Solarzelle mit inter-digitalen Rückkontakten und Vertiefungen auf der Vorderseite bekannt. Die Vertiefungen sind so dotiert, daß sich zum Volumenhalbleiter ein pn-Übergang ergibt. Diese Vertiefungen werden als Energieeinfang-Vertiefungen bezeichnet und dienen der Erhöhung der Absorptionswahrscheinlichkeit, selbst bei einer Mehrfachreflektion innerhalb einer Vertiefung. Das Substrat ist ein (110)-Wafer und die Vertiefungen werden durch (111)-Ebenen bzw. äquivalente Ebenen begrenzt. Entsprechend dem angegebenen Zweck der Verbesserung des Strahlungseinfangs, öffnen sich alle Vertiefungen zur Vorderseite hin.

Aufgabe der vorliegenden Erfindung ist es, eine Solarzelle ohne abschattende Vorderseitenkontakte anzugeben, die einfach und preisgünstig herzustellen ist und die weitere Erfordernisse für eine Hochleistungssolarzelle erfüllt.

Diese Aufgabe wird erfindungsgemäß durch eine Solarzelle nach Anspruch 1 gelöst. Bevorzugte Ausgestaltungen der Erfindung sowie ein Verfahren zur Herstellung sind weiteren Ansprüchen zu entnehmen.

Die erfindungsgemäße Solarzelle ist aus einem kristallinen Siliziumsubstrat mit (110)-Orientierung aufgebaut. Dieses Material hat den Vorteil, daß es vertikal zur (110)-Oberfläche ausgerichtete (111)-Ebenen aufweist. Mittels einer an der Kristallstruktur orientierten anisotropen Ätzung ist es so möglich, Vertiefungen, Löcher oder Durchbrechungen mit hohem Aspektverhältnis und zwei vertikalen Seitenwänden im (110)-Substrat zu erzeugen. Die erfindungsgemäße Solarzelle weist eine Vielzahl von parallel zu (111)-Ebenen ausgerichteten, länglichen Schlitzen auf, die durch die gesamte Dicke des Siliziumsubstrats reichen bzw. dieses durchbrechen. Die inneren Oberflächen der Schlitze weisen eine hohe Dotierung entsprechend dem Leitfähigkeitstyp der zumindest auf der Vorderseite erzeugten flachen Emitterschicht auf. Auf der Rückseite der Solarzelle befindet sich ein gridförmiges erstes Kontaktmuster zum elektrischen Anschluß des Bulkmaterials. Interdigital dazu ist ein zweites gridförmiges Kontaktmuster auf der Rückseite angeordnet, welches mit den Schlitzen zumindest teilweise überlappt und so den elektrischen Anschluß der Emitterschicht gewährleistet.

Die Vorderseite der erfindungsgemäßen Solarzelle ist bis auf die Schlitze ungestört und weist eine hochwertige Oberfläche auf, die eine gute Passivierung und eine wirkungsvolle Antireflexschicht ermöglicht. Wegen der guten anisotropen Ätzbarkeit im (110)-orientierten Silizium können die Schlitze mit hohen Aspektverhältnissen von beispielsweise 1:600 im Siliziumsubstrat erzeugt werden. Auf diese Weise gelingt es, die Größe der Schlitze und damit die Oberflächenverluste zu minimieren. Anisotrop in (110)-Silizium geätzte Schlitze besitzen Seitenwände, die aus (111)-Ebenen bestehen. Zwei dieser Ebenen sind vertikal zur Substratoberfläche angeordnet, während die beiden "Schmalseiten" schräg durch das Substrat verlaufen. Bei Ätzung von der Rückseite des Siliziumsubstrats her verjüngt sich somit der Querschnitt der Schlitze zur Vorderseite hin, so daß dadurch die Oberflächenverluste durch die Schlitze auf der Vorderseite weiter reduziert werden. Die längliche Ausdehnung der Schlitze erleichtert die Justierung des zweiten Kontaktmusters, welches die Schlitze auf der Rückseite überlappt.

In den Schlitzen ist das Siliziumsubstrat hoch dotiert. Dadurch werden elektrisch ausreichend leitfähige Strompfade geschaffen, die die Vorderseite der Solarzelle mit der Rückseite, beziehungsweise mit dem dort aufgebrachten Kontaktmuster verbinden. Durch ein ausreichend dichtes Muster an Schlitzen und durch die relativ geringe Substratdicke bleiben die Strompfade für auf der Vorderseite gesammelte Ladungsträger kurz. So ist auch der Serienwiderstand der Solarzelle gering und es wird ein hoher Füllfaktor möglich.

In einer vorteilhaften Ausgestaltung der Erfindung wird als Substrat ein sogenannter Trikristallwafer verwendet, wie er beispielsweise aus einem Artikel von G. Martinelli in Solid State Phenomena Vol. 32 to 33, 1993, pp 21 - 26 bekannt ist. Ein solcher Wafer weist drei gegeneinander verkippte monokristalline Bereiche auf, die jeweils für sich (110)-orientiert sind. Die Grenzflächen zwischen den monokristallinen Bereichen verlaufen radial zur Wafermitte hin, so daß die monokristallinen Bereiche Kreissektoren des Trikristallwafers bilden. Zwei der drei Grenzflächen sind dabei Zwillingskorngrenzen erster Ordnung an (111)-Ebenen, die besonders störstellenarm sind.

Eine aus einem solchen Trikristallwafer gefertigte erfindungsgemäße Solarzelle hat den Vorteil, daß die mechanische Stabilität des Wafers und damit der Solarzelle im Vergleich zu einem monokristallinen Substrat stark erhöht ist. Auf diese Weise läßt sich die Substratdicke auf Werte von 30 bis 70 um reduzieren, ohne daß bei der Verarbeitung eine erhöhte Bruchgefahr in Kauf genommen werden muß. Für die Erfindung ist der Trikristallwafer besonders geeignet, da er ausschließlich (110)-orientierte Oberflächen besitzt, bzw. (110)-orientierte Siliziumsubstrate erstmals ausreichend verfügbar macht. Das Kristallziehen monokristalliner (110)-orientierter Stäbe ist erheblich schwieriger als das von herkömmlichen (100)-Siliziumstäben, da es schneller zu Kristallversetzungen und Strukturverlust kommt, der zum vorzeitigen Abbruch des Ziehverfahrens führt. Das Kristallziehen eines Trikristalls ist dagegen 2 bis 3 mal schneller als bei (110)-orientierten Siliziumstäben. Am Stabende ist kein Konus erforderlich. Es läßt sich daher quasikontinuierlich und versetzungsfrei durchführen. Ein Tiegel kann bis zu zehn mal genutzt werden.

Eine Solarzelle mit einem dünneren Siliziumsubstrat hat neben der Materialersparnis noch zusätzliche technische Vorteile. Die Anforderung an eine Hochleistungssolarzelle, daß die Diffusionslänge der Minoritätsladungsträger größer als die dreifache Dicke des Substrats ist, wird mit einem dünneren Substrat bereits von einem Material niedrigerer elektronischer Güte erfüllt. Ein dünneres Siliziumsubstrat führt daher in einer Solarzelle zu geringeren Rekombinationsverlusten als ein dickeres Substrat.

Eine Solarzelle mit einem trikristallinen Siliziumsubstrat ist auch bei einer Vielzahl von das Substrat durchbrechenden Schlitzen ausreichend stabil. Dennoch ist es vorteilhaft, wenn die parallel zu (111)-Ebenen verlaufenden Schlitze gegeneinander versetzt sind, so daß in ein und derselben (111)-Ebene nicht mehrere Schlitze hintereinander angeordnet sind, die einen Bruch des Substrates parallel zu Kristallebenen durch die vorgegebene "Perforation" unterstützen könnten.

Ein erstes und ein zweites Kontaktmuster auf der Rückseite der Solarzelle werden vorzugsweise als Dickfilmkontakte und insbesondere als aufzusinternde leitfähige Paste aufgebracht. Erstes und zweites Kontaktmuster bilden eine interdigitale Struktur, bei der fingerförmige Kontakte alternierend angeordnet sind, wobei die fingerförmigen Kontakte des ersten und zweiten Kontaktmusters wie die Zähne eines Reißverschlusses ineinandergreifen. Jedes Kontaktmuster umfaßt zumindest eine Busstruktur, die sämtliche fingerförmigen Kontakte miteinander verbindet. Vorzugsweise ist eine der Busstrukturen umlaufend in der Nähe des Randes der Solarzellenrückseite angeordnet. Vorzugsweise sind die Flächenanteile von erstem und zweitem Kontaktmuster annähernd gleich, da für beide Ladungsträgertypen gleiche Ladungsmengen transportiert werden müssen und so der Serienwiderstand minimiert ist.

Das Verfahren zur Herstellung der erfindungsgemäßen Solarzelle wird im folgenden anhand von Ausführungsbeispielen und der dazugehörigen zehn Figuren näher erläutert. Die Figuren sind dabei ausschließlich den Ausführungsbeispielen zugehörig und nicht als einschränken d zu betrachten.
- Figuren 1 bis 7: zeigen anhand schematischer Querschnitte durch das Substrat verschiedene Verfahrensstufen bei der Herstellung der Solarzelle.
- Figuren 8 und 9: zeigen anhand schematischer Querschnitte durch das Substrat verschiedene Verfahrensstufen einer Verfahrensvariante
- Figur 10: zeigt einen Schlitz in perspektivischer Draufsicht auf ein Siliziumsubstrat.
- Figur 11: zeigt einen Trikristallwafer in der Draufsicht.
- Figur 12: zeigt eine mögliche Anordnung für erstes und zweites Kontaktmuster auf der Rückseite.

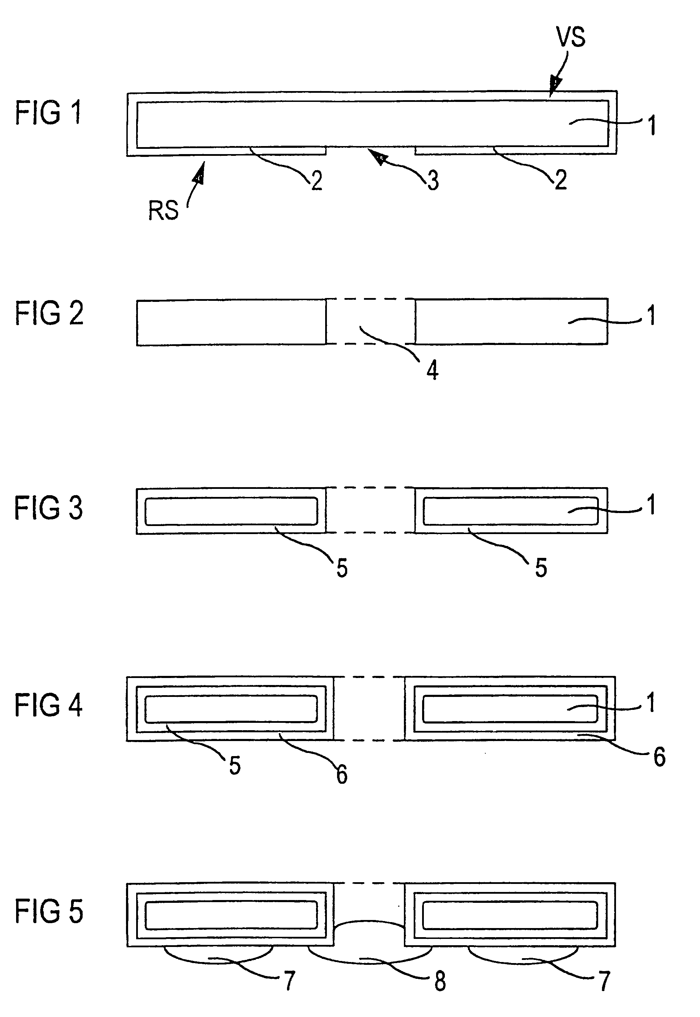

Ausgangspunkt für das erfindungsgemäße Verfahren ist ein beispielsweise p-dotierter Siliziumwafer 1 mit (110)-Orientierung. Im ersten Schritt werden die Schlitze bzw. ein Muster von Schlitzen erzeugt. Dazu wird zunächst rundum eine Oxid- oder Nitridschicht 2 ganzflächig auf Vorderseite VS und Rückseite RS aufgebracht. Photolithographisch werden anschließend in dieser Oxid- oder Nitridschicht 2 rechteckige, dem Schlitzmuster entsprechende Öffnungen 3 definiert und frei geätzt. In Figur 1 ist diese Verfahrensstufe anhand eines schematischen und nicht maßstabsgetreuen Querschnitts durch ein Siliziumsubstrat dargestellt.

Durch kristallorientiertes alkalisches Ätzen werden nun entsprechend dem in der Maskenschicht 2 definierten Muster von Öffnungen 3 Schlitze 4 im Substrat 1 erzeugt. Figur 2 stellt diesen Zustand nach Entfernen der Maskenschicht 2 dar.

Figur 3: Durch eine rundum erfolgende Phosphordotierung wird auf sämtlichen Oberflächen des Siliziumsubstrats 1 einschließlich der Schlitze eine flache, n⁺-dotierte Emitterschicht 5 erzeugt, zum Beispiel in einer Tiefe von 0,3 bis 2µm.

Figur 4: Im nächsten Schritt wird rundum auf allen Oberfächen eine Passivierungsschicht 6 aufgebracht, beispielsweise eine typischerweise 70nm dicke Oxid- oder Nitridschicht.

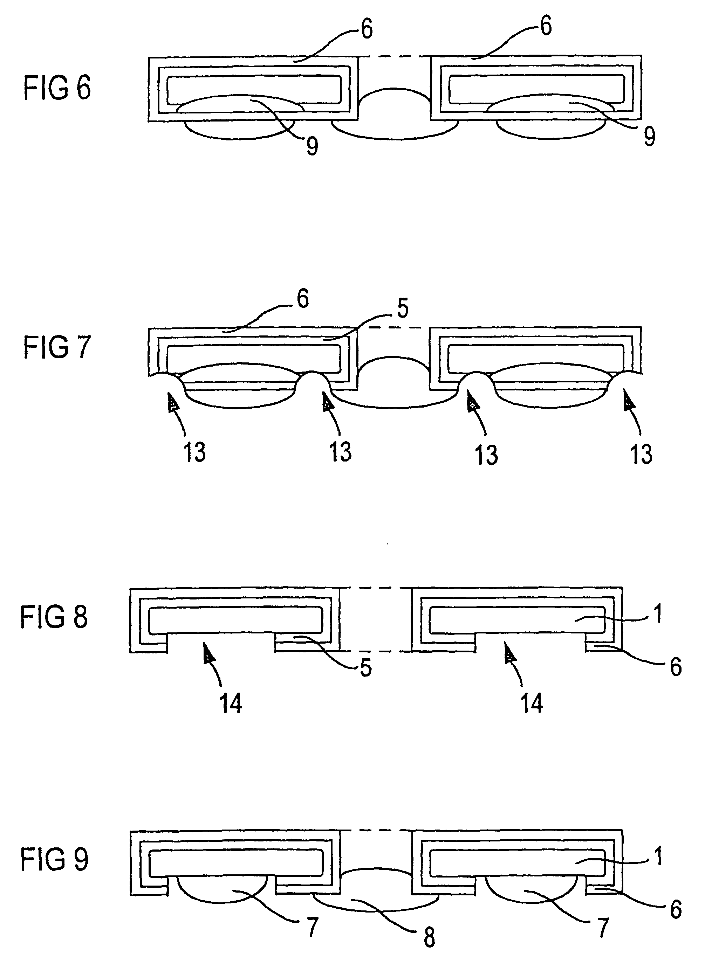

Figur 5: Im nächsten Schritt werden die elektrischen Kontakte auf der Rückseite in einer Dickfilmtechnik aufgebracht. Für das erste Kontaktmuster 7 werden dazu beispielsweise fingerförmige Kontakte zur Kontaktierung des Bulk-Materials, also zur Kontaktierung des inneren p-dotierten Substratbereiches, neben den Schlitzen 4 auf der Rückseite RS aufgebracht. Dies kann beispielsweise durch Aufdrucken einer Silber- oder Aluminiumpartikel enthaltenden sinter- und leitfähigen Siebdruckpaste erfolgen. Die Paste enthält entweder Aluminium oder einen anderen, eine p-Dotierung erzeugenden Dotierstoff, zum Beispiel Bor. Ein zweites Kontaktmuster 8 wird zumindest teilweise über den Schlitzen 4 aufgebracht, beispielsweise durch Aufdrucken einer silberhaltigen leitfähigen Paste. Erstes und zweites Kontaktmuster 7 bzw. 8 sind gridförmig ausgebildet und umfassen je zumindest eine Busstruktur und davon ausgehende fingerförmige Kontakte. Die Anordnung der beiden Kontaktmuster auf der Rückseite des Substrates erfolgt dabei so, daß die fingerförmigen Kontakte interdigital ineinander greifen und räumlich voneinander getrennt sind. Figur 5 zeigt die Anordnung nach dieser Verfahrensstufe.

Figur 6: Im nächsten Schritt werden die Kontakte eingebrannt und gesintert, wobei die Passivierungsschicht 6 unter den Kontaktmustern 7 und 8 elektrisch leitend legiert wird. Der in der Paste für das erste Kontaktmuster 7 enthaltene Dotierstoff erzeugt eine p⁺ Dotierung 9, die die Emitterschicht 5 überkompensiert und den ohm'schen Kontakt zum innen gelegenen p-dotierten Bereich des Substrats 1 herstellt. Das Material des zweiten Kontaktmusters 8 erzeugt eine leitende Verbindung zum n⁺-dotierten Bereich 5, der Emitterschicht.

Figur 7: Mit Hilfe von erstem und zweitem Kontaktmuster 7 bzw. 8 als selbstjustierende Maske kann im nächsten Schritt der pn-Übergang zwischen erstem und zweitem Kontaktmuster gegebenenfalls aufgetrennt werden, beispielsweise durch Plasmaätzen, wobei zwischen erstem und zweitem Kontaktmuster Vertiefungen 13 entstehen. Wenn die p⁺ Dotierung 9, die gleichzeitig ein back surface field (BSF) darstellt, eine leitende Verbindung des Kontaktmusters 7 zur Emitterschicht verhindert, ist das Plasmaätzen aber nicht erforderlich.

Figur 8: In einer Verfahrensvariante (anschließend an die Verfahrensstufe entsprechend Figur 4) wird die Passivierungsschicht 6 und die Emitterschicht 5 in einem lift off Verfahren, zum Beispiel durch eine kurzes Plamaätzen, in einem Bereich 14 entfernt, der zur Aufnahme des ersten Kontaktmusters vorgesehen ist. Er ist daher etwas größer dimensioniert als das erste Kontaktmuster.

Figur 9: Anschließend werden erstes und zweites Kontaktmuster 7,8 zum Beispiel durch Aufdrucken aufgebracht und gegebenenfalls eingebrannt. Das erste Kontaktmuster kann dabei wiederum eine zur Erzeugung eines BSF geeignete Dotierung enthalten.

Möglich ist es jedoch auch, im Anschluß an den in Figur 4 dargestellten Zustand zunächst das zweite Kontaktmuster 8 aufzubringen und als Maske für das lift off Verfahren zum Entfernen von Passivierungsschicht 6 und Emitterschicht 5 zu verwenden, wobei den Bereichen 14 entsprechende und bis ins bulk Material reichende Ausnehmungen erzeugt werden. In diesen Ausnehmungen wird anschließend das erste Kontaktmuster 7 aufgebracht. In dieser Variante ist es vorteilhaft, das zweite Kontaktmuster 8 mit größerer Fläche zu erzeugen als das erste Kontaktmuster 7, um eine maximale Emitterfläche nach dem lift off Verfahren zu behalten.

In jedem Fall erfolgt das Aufbringen von erstem und zweiten Kontaktmuster 7 und 8 so, daß die beiden nicht überlappen und elektrisch voneinander getrennt sind.

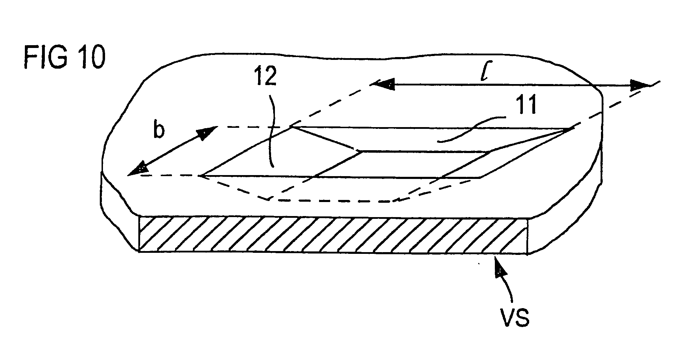

Figur 10 zeigt in perspektivischer Darstellung die Rückseite des Siliziumsubstrats 1 mit einem der Schlitze 4. Dieser weist zwei gegenüberliegende vertikale Wände 11 auf, die (111)-Ebenen im Substrat entsprechen. Die Schmalseiten der Schlitze 4 dagegen sind von schräg dazu verlaufenden Kristallflächen 12 begrenzt, die ebenfalls (111)-Ebenen darstellen. Bei der Definition des Schlitzmusters in der Maskenschicht 2 zu Anfang des Verfahrens wird darauf geachtet, daß die Längsachse der Schlitze parallel zu den vertikalen (111)-Ebenen angeordnet ist. Länge l und Breite b der Schlitze (auf der Rückseite) werden so gewählt, daß beim kristallorientierten Ätzen grade eben eine das Substrat 1 durchbrechende Öffnung erzeugt ist. Die Schlitzbreite b wird auf 5 bis 50 µm eingestellt und liegt beispielsweise bei 15 bis 20 µm. Die Schlitzlänge l ist abhängig von der Dicke des Siliziumsubstrats l. Vorzugsweise wird die Länge l so gewählt, daß der virtuelle Schnittpunkt der die Schmalseiten des Schlitzes begrenzenden Flächen 12 knapp über der Vorderseite VS des Siliziumsubstrats l angeordnet ist. Auf diese Weise wird ein von der Vorderseite VS des Substrats 1 betrachteter Schlitz erhalten, dessen "Länge" b entspricht und dessen "Breite" parallel zur Schlitzlänge l minimiert ist.

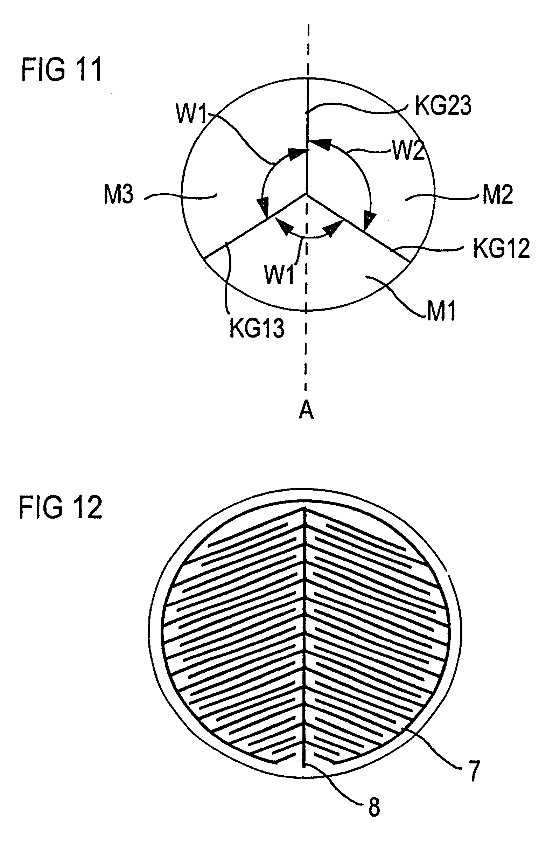

Figur 11 zeigt einen Trikristallwafer, der vorzugsweise als Substrat für die erfindungsgemäße Solarzelle eingesetzt wird. Dieser weist drei monokristalline Bereiche M1, M2, M3 auf, die alle (110)-orientiert sind aber gegeneinander verkippt sind. In der Figur ist der Trikristallwafer so angeordnet, daß zwischen den monokristallinen Bereichen M1 und M2 eine Zwillingskorngrenze KG12 erster Ordnung mit (111)-Ebenen als kornbegrenzenden Kristallflächen entsteht. Auch die Korngrenze KG13 zwischen M1 und M3 ist eine Zwillingskorngrenze erster Ordnung mit begrenzenden (111)-Kristallebenen. Ein optimal gewachsener Trikristall mit den zwei Zwillingskorngrenzen erster Ordnung besitzt ideale Innenwinkel zwischen den verschiedenen monokristallinen Bereichen, die für W1 exakt 109,47° und für W2 und W3 exakt 125,26° betragen. Doch auch davon abweichende Innenwinkel führen zu einem stabilen Trikristallwafer. Dieser kann durch Sägen aus entsprechenden Trikristallstäben erhalten werden, wobei bis hinab zu Waferdicken von 30 µm eine sichere Handhabung des entsprechenden Wafers ohne erhöhte Bruchgefahr gewährleistet ist. Für eine Solarzelle bevorzugte Waferdicken liegen beispielsweise im Bereich von 60 bis 150 µm.

Figur 11 zeigt ein Ausführungsbeispiel für die Anordnung von erstem und zweiten Kontaktmuster auf der Rückseite eines Trikristallwafers. Entsprechend der in Figur 9 dargestellten Orientierung bilden die beiden unteren Schenkel des durch die Korngrenzen gebildeten "Sterns" Zwillingskorngrenzen erster Ordnung. Vorzugsweise werden die Schlitze im Trikristallwafer so angeordnet, daß deren Länge l parallel zu einer der Zwillingskorngrenzen erster Ordnung ausgerichtet ist. Vorzugsweise sind die Schlitze parallel zu der Zwillingskorngrenze erster Ordnung ausgerichtet, die dem Schlitz am nächsten liegt. Entsprechend der in Figur 9 dargestellten Anordnung des Trikristallwafers wird das Schlitzmuster in einer ersten Waferhälfte links der gedachten Achse A parallel zur Korngrenze KG13 ausgerichtet, in der rechts von der Achse A gelegenen Waferhälfte dagegen parallel zur Korngrenze KG12. Die Schlitze sind vorzugsweise versetzt gegeneinander angeordnet, so daß in einer Reihe nebeneinander angeordnete Schlitze nicht in ein und derselben (111)-Ebene zu liegen kommen. Vorzugsweise sind sie um mehr als eine ganze Schlitzbreite gegeneinander versetzt.

Ein dazu passendes zweites Kontaktmuster 8, das sämtliche Schlitze überlappt ist beispielsweise in Figur 12 dargestellt. Das erste Kontaktmuster 7 weist eine Busstruktur auf, die umlaufend in der Nähe des Substratrandes angeordnet ist. Davon ausgehende Kontaktfinger weisen schräg zur zentralen Achse des Substrats. Das zweite Kontaktmuster 8 dagegen weist eine zentrale Busstruktur auf, die beispielsweise parallel zur in Figur 9 dargestellten Achse A angeordnet ist. Die davon ausgehenden fingerförmigen Kontakte sind interdigital zur ersten Kontaktstruktur 7 angeordnet, ohne diese zu berühren. Die geometrische Ausrichtung des ersten Kontaktmusters 8 ist im Ausführungsbeispiel so gewählt, daß die Kontaktfinger parallel zur Länge l der Schlitze ausgerichtet sind und diese daher in der Länge überlappen. Das erste Kontaktmuster 7 überlappt keinen der Schlitze. Möglich ist es jedoch auch, die Zuordnung der Kontaktmuster zu den p- bzw. n-dotierten Gebieten der Solarzelle zu vertauschen, so daß beispielsweise das Kontaktmuster mit der umlaufenden Busstruktur die Schlitze überlappt und daher die n-dotierten Gebiete kontaktiert, während das Kontaktmuster mit der zentralen Busstruktur zur Kontaktierung des p-dotierten Bulk-Materials dient.

Die Breite der fingerförmigen Kontakte für erstes und zweites Kontaktmuster wird beispielsweise auf ca. 300 µm eingestellt. Ein solches Kontaktmuster läßt sich mit herkömmlichen Siebdrucktechniken sicher und reproduzierbar herstellen. Es sind jedoch auch deutlich breitere oder schmälere fingerförmige Kontakte möglich. Entsprechend dem Abstand der Schlitze sind die fingerförmigen Kontakte einer Kontaktstruktur ca. 3 mm voneinander entfernt.

Anschließend können noch eine oder mehrere Antireflexschichten geeigneter Dicke auf der Passivierungsschicht 6 aufgebracht werden, beispielsweise weitere Oxid-, Nitrid- oder Titanoxidschichten.

Eine so hergestellte erfindungsgemäße Solarzelle weist alle Voraussetzungen auf, die zum Erreichen eines Sammelwirkungsgrads von über 20 Prozent erforderlich sind. Die Forderung, daß die Diffusionslänge für die Minoritätsladungsträger größer als die dreifache Dicke des Siliziumsubstrats ist, wird mit der erfindungsgemäßen Solarzelle bereits mit preiswertem CZ-Silizium erfüllt, bei der die Diffusionslänge L die Substratdicke d um das 1,5-fache übertrifft (bei d = 60µm, L ≥ 120µm). Eine hohe Oberflächengüte, die sich durch eine niedrige Oberflächenrekombinationsgeschwindigkeit S ausdrückt, läßt sich sowohl auf Vorder- als auch auf Rückseite mit Passivierungsschichten in einfacher Weise sicher erreichen. Über dem Emitter läßt sich eine hohe Oberflächengüte von S < 1000 cm/s mit einer Oxidpassivierung einstellen. Für die Güte der Rückseite wird eine Oberflächenrekombinationsgeschwindigkeit S < 100 cm/s gefordert, die sich bei der erfindungsgemäßen Solarzelle auch ohne weitere Maßnahmen erreichen läßt. Geforderte Abschattungsverluste unter 4 Prozent werden mit der erfindungsgemäßen Solarzelle ebenfalls übererfüllt, da sie praktisch keine Abschattung aufweist. Niedrige geforderte Reflexionswerte < 4 Prozent werden mit Standard-Antireflexschichten erhalten. Auch ein hoher Füllfaktor von zumindest 80 Prozent wird mit der Erfindung erreicht.

Ein weiterer Vorteil von Solarzellen mit ausschließlich auf der Rückseite aufgebrachten Kontakten besteht darin, daß eine maschinelle Verschaltung verschiedener Solarzellen zu einem Modul erleichtert ist, da zum Anlöten entsprechender Verbindungen keine Durchführungen auf die Vorderseite mehr erforderlich sind. Dies vereinfacht das Verschaltungsverfahren und erhöht die Verfahrenssicherheit. Die erfindungsgemäßen Solarzellen sind daher vollautomatisiert und großtechnisch herstellbar.

## Patentansprüche

1. Solarzelle
- mit einem kristallinen Siliziumsubstrat (1), das auf Vorderseite (VS) und Rückseite (RS) kristallographische (110) Ebenen aufweist
- mit einer flachen dotierten Emitterschicht (5) auf zumindest der Vorderseite (VS)
- mit einer Vielzahl von parallel zu kristallographischen (111) Ebenen ausgerichteten, länglichen Schlitzen (4), die durch die gesamte Dicke des Siliziumsubstrats reichen
- mit einer dem Leitfähigkeitstyp der Emitterschicht entsprechenden hohen Dotierung in den Schlitzen
- mit einem ersten gridförmigen Kontaktmuster (7) auf der Rückseite zum elektrischen Anschluß des Bulkmaterials
- mit einem zweiten gridförmigen Kontaktmuster (8) auf der Rückseite zum elektrischen Anschluß der Emitterschicht, wobei das zweite Kontaktmuster (8) die Schlitze (4) zumindest teilweise überlappt,und wobei
- die Schlitze (4) von der Rückseite (RS) her kristallographisch anisotrop geätzt sind, so daß in den Schlitzen (111) Ebenen (11, 12) als begrenzende Oberflächen freigelegt sind, wobei sich die Schlitze durch zwei schräg zur Oberfläche der Solarzelle verlaufende wände (12) zur Vorderseite (VS) der Solarzelle hin verjüngen.

2. Solarzelle nach Anspruch 1, bei dem das Siliziumsubstat (1) einen Trikristallwafer umfaßt, der drei gegeneinander verkippte, monokristalline, jeweils (110) orientierte Bereiche aufweist, deren gegenseitige Grenzflächen (KGn, n+1) radial verlaufen und Kreissektoren des Trikristallwafers bilden, und bei dem zwei der Grenzflächen Zwillingskorngrenzen erster Ordnung an (111) Ebenen bilden.

3. Solarzelle nach einem der Ansprüche 1 oder 2, bei der erstes und zweites Kontaktmuster (7, 8) aufgedruckte Dickfilmkontakte umfassen.

4. Solarzelle nach einem der Ansprüche 1 bis 3, bei der die Schlitze (4) regelmäßig über die Oberfläche der Solarzelle verteilt sind und eine Breite von 5 bis 50 µm aufweisen.

5. Solarzelle nach einem der Ansprüche 1 bis 4, bei der die Schlitze (4) parallel zu (111) Ebenen verlaufen, aber gegeneinander versetzt sind.

6. Solarzelle nach einem der Ansprüche 1 bis 5, bei dem erstes und zweites Kontaktmuster (7, 8) fingerförmige, interdigital ineinander greifende Kontakte und jeweils zumindest eine Busstruktur umfassen, die jeweils sämtliche fingerförmigen Kontakte miteinander verbindet, wobei eine der Busstrukturen (7) auf der Rückseite (RS) außen in der Nähe des Solarzellenrands umlaufend angeordnet ist.

7. Verfahren zum Herstellen einer Solarzelle mit auf die Rückseite (RS) verlegten Vorderseitenkontakten nach Anspruch 1,
- bei dem ein (110) orientiertes kristallines Siliziumsubstrat (1) verwendet wird,
- bei dem von der Rückseite her alkalisch, kristallorientiert und maskiert eine Vielzahl von durch die gesamte Dicke des Siliziumsubstrats reichenden Schlitzen (4) parallel zu (111) Ebenen in das Siliziumsubstrat geätzt wird,
- bei dem eine flache Emitterschicht (5) durch Diffusion eines Dotierstoffs erzeugt wird,
- bei dem auf der Rückseite (RS) ein erstes und zweites Kontaktmuster (7,8) durch Aufdrucken und Einbrennen einer leitfähigen Paste erzeugt werden, wobei das zweite Kontaktmuster (8) die Schlitze (4) überlappend angeordnet wird.

8. Verfahren nach Anspruch 7,
- bei dem die Diffusion des Dotierstoffs rundum erfolgt,
- bei dem die Dotierung der Emitterschicht (5) im Bereich des ersten Kontaktmusters (7) durch entsprechende Dotierung der Paste beim Einbrennen überkompensiert werden
- bei dem die Emitterschicht (5) auf der Rückseite zwischen erstem und zweitem Kontaktmuster aufgetrennt wird.

9. Verfahren nach Anspruch 7 oder 8, bei dem das Ätzen der Schlitze (4) mit Hilfe einer photolithographisch strukturierten Ätzmaske (2) aus Nitrid oder Oxid erfolgt.

10. Verfahren nach einem der Ansprüche 7 bis 9, bei dem das Ätzen der Schlitze (4) zeitlich kontrolliert durchgeführt und beendet wird, wenn gerade eben eine durch das Siliziumsubstrat (1) reichende Öffnung entstanden ist.

11. Verfahren nach einem der Ansprüche 7 bis 10, bei dem die Länge der Schlitze (4) in Abhängigkeit von der Dicke des Siliziumsubstrats (1) so gewählt wird, daß der virtuelle Schnittpunkt der beiden schräg zur Oberfläche des Siliziumsubstrats verlaufenden und einen Schlitz begrenzenden (111) Ebenen (12) gerade eben außerhalb des Siliziumsubstrats über der Vorderseite (VS) angeordnet ist.

12. Verfahren nach einem der Ansprüche 7 bis 11, bei dem die Emitterschicht (5) auf der Rückseite (RS) zwischen erstem und zweitem Kontaktmuster durch maskiertes Ätzen aufgetrennt wird, wobei die Kontaktmuster (7, 8) als Maske verwendet werden.

## Claims

1. A solar cell comprising:
- a crystalline silicon substrate (1) exhibiting crystallographic (110) planes on a front side (VS) and a rear side (RS);
- a flat doped emitter layer (5) on at least the front side (VS);
- a plurality of elongated slots (4) aligned parallel to crystallographic (111) planes and extending through the entire thickness of the silicon substrate;
- a high doping, corresponding to a conductivity type of the emitter layer, in the slots;
- a first grid-like contact pattern (7) on the rear side for electrical connection of the bulk material;
- a second grid-like contact pattern (8) on the rear side for electrical connection of the emitter layer, the second contact pattern (8) overlapping the slots (4) at least in part; and
wherein the slots (4) are crystallographically etched anisotropically from the rear side (RS) so that (111) planes (11, 12) as delimiting surfaces are exposed in the slots, the slots tapering toward the front side (VS) of the solar cell with two walls (12) extending at an angle to the surface of the solar cell.

2. A solar cell according to claim 1, wherein the silicon substrate (1) comprises a tricrystal wafer having three monocrystalline, respectively (110)-oriented regions tilted toward one another, mutual boundary areas of the regions (KGn, n+1) extending radially and forming sectors of the tricrystal wafer, and two of the boundary areas forming first-order twin grain boundaries on (111) planes.

3. A solar cell according to any of claims 1 or 2, wherein the first and second contact patterns (7, 8) comprise imprinted thick-film contacts.

4. A solar cell according to any of claims 1 to 3, wherein the slots (4) are regularly distributed over the surface of the solar cell and have a width of 5 to 50 µm.

5. A solar cell according to any of claims 1 to 4, wherein the slots (4) extend parallel to (111) planes, but are offset against one another.

6. A solar cell according to any of claims 1 to 5, wherein the first and second contact patterns (7, 8) comprise finger-like contacts which interdigitally engage with one another and at least one bus structure which respectively connects all the finger-like contacts together, one of the bus structures (7) being arranged circumferentially on the outside proximate to an edge of the solar cell on the rear side (RS).

7. A method of producing a solar cell comprising front-side contacts displaced to the rear side (RS) according to claim 1, comprising
- providing a (110)-oriented crystalline silicon substrate (1);
- etching, from the rear side, in an alkaline, crystal-oriented and masked manner parallel to (111) planes into the silicon substrate, a plurality of slots (4) extending through the entire thickness of the silicon substrate;
- producing by diffusion of a dopant a flat emitter layer (5) ;
- producing on the rear side (RS), by imprinting and burning-in a conductive paste, a first contact pattern and a second contact pattern (7, 8), the second contact pattern (8) being disposed to overlap the slots (4).

8. A method according to claim 7, wherein
- diffusion of the dopant takes place all over;
- doping the emitter layer (5) in the region of the first contact pattern (7) is overcompensated by correspondingly doping the paste during the burning-in process;
- the emitter layer (5) on the rear side is separated between first and second contact patterns.

9. A method according to claims 7 or 8, wherein etching the slots (4) is performed with a photo lithographically structured etching mask (2) made of nitride or oxide.

10. A method according to any of claims 7 to 9, wherein etching the slots (4) is performed with controlled timing and completed just when an opening which extends the silicon substrate (1) has been produced.

11. A method according to any of claims 7 to 10, wherein the length of the slots (4) is chosen in accordance with the thickness of the silicon substrate (1) such that the virtual intersection of both (111) planes (12) extending at an angle to the surface of the silicon substrate and delimiting a slot is just outside the silicon substrate above the front side (VS).

12. A method according to any of claims 7 to 11, wherein the emitter layer (5) on the rear side (RS) is separated between the first and second contact patterns by means of masked etching, the contact patterns (7, 8) being used as a mask.

## Revendications

1. Pile solaire, comprenant :
- un substrat de silicium cristallin (1), qui présente du côté avers (VS) et du côté revers (RS) des plans cristallographiques (110),
- une couche d'émetteur (5) dopée, plane, sur au moins le côté avers (VS),
- un grand nombre d'entailles allongées (4) qui sont orientées parallèlement à des plans cristallographiques (111) et qui passent à travers la totalité de l'épaisseur du substrat de silicium,
- un dopage élevé, correspondant au type de conductibilité de la couche d'émetteur, dans les entailles,
- un premier modèle de contacts (7) en forme de grille sur le côté revers pour le raccordement électrique de la matière de base, et
- un deuxième modèle de contacts (8) en forme de grille sur le côté revers pour le raccordement électrique de la couche d'émetteur, le deuxième modèle de contacts (8) recouvrant au moins partiellement les entailles (4),
- les entailles (4) étant gravées d'une manière cristallo-graphiquement anisotrope à partir du côté revers (RS), de façon que, dans les entailles, des plans (111) (11, 12) soient mis à nu comme surfaces limitatrices, les entailles s'amincissant en direction du côté avers (VS) de la pile solaire par deux parois (12) qui s'étendent de manière inclinée par rapport à la surface de la pile solaire.

2. Pile solaire suivant la revendication 1, dans laquelle le substrat de silicium (1) comporte une tranche tricristalline, qui présente trois zones orientées chacune (110), monocristallines, basculées l'une par rapport à l'autre, dont les surfaces limites opposées (KGn, n+1) s'étendent radialement et forment des secteurs de cercle dans la tranche tricristalline, et dans laquelle deux des surfaces limites forment des limites intergranulaires maclées du premier ordre sur des plans (111).

3. Pile solaire suivant l'une des revendications 1 et 2, dans laquelle les premier et deuxième modèles de contacts (7, 8) comportent des contacts à couche épaisse, imprimés.

4. Pile solaire suivant l'une des revendications 1 à 3, dans laquelle les entailles (4) sont réparties de manière régulière sur la surface de la pile solaire et présentent une largeur de 5 à 50 µm.

5. Pile solaire suivant l'une des revendications 1 à 4, dans laquelle les entailles (4) s'étendent parallèlement aux plans (111), mais sont décalées l'une par rapport à l'autre.

6. Pile solaire suivant l'une des revendications 1 à 5, dans laquelle les premier et deuxième modèles de contacts (7, 8) comportent des contacts en forme de doigts, qui s'interpénètrent de manière inter-digitée, et respectivement au moins une structure de bus qui relie chacune l'ensemble des contacts en forme de doigts, une des structures de bus (7) étant agencée périphériquement sur le côté revers (RS) à l'extérieur, à proximité du bord de la pile solaire.

7. Procédé de préparation d'une pile solaire comportant des contacts de côté avers déplacés sur le côté revers (RS), suivant la revendication 1, dans lequel
- on utilise un substrat de silicium cristallin (1) orienté (110),
- à partir du côté revers, on grave dans le substrat de silicium de manière alcaline, orientée sur les cristaux et masquée, un grand nombre d'entailles (4) qui passent à travers la totalité de l'épaisseur du substrat de silicium et sont parallèles aux plans (111),
- on produit une couche d'émetteur plane (5) par diffusion d'une matière de dopage,
- sur le côté revers (RS), on produit un premier et un deuxième modèle de contacts (7, 8) par impression et cuisson d'une pâte conductrice, le deuxième modèle de contacts (8) étant agencé de façon à recouvrir les entailles (4).

8. Procédé suivant la revendication 7, dans lequel
- la diffusion de la matière de dopage est effectuée tout autour,
- le dopage de la couche d'émetteur (5) dans la zone du premier modèle de contacts (7) est surcompensé par un dopage correspondant de la pâte lors de la cuisson, et
- la couche d'émetteur (5) est, sur le côté revers, séparée entre un premier modèle de contacts et un deuxième.

9. Procédé suivant l'une des revendications 7 et 8, dans lequel la gravure des entailles (4) est effectuée à l'aide d'un masque (2) en nitrure ou oxyde qui est photolithographiquement structuré.

10. Procédé suivant l'une des revendications 7 à 9, dans lequel la gravure des entailles (4) est effectuée et achevée de manière contrôlée dans le temps, lorsque directement précisément une ouverture passant à travers le substrat de silicium (1) est obtenue.

11. Procédé suivant l'une des revendications 7 à 10, dans lequel la longueur des entailles (4) est choisie en fonction de l'épaisseur du substrat de silicium (1) de façon que le point de croisement virtuel entre les deux plans (111) (12) qui s'étendent de manière inclinée par rapport à la surface du substrat de silicium et limitent une entaille soit agencé directement précisément à l'extérieur du substrat de silicium au-dessus du côté avers (VS).

12. Procédé suivant l'une des revendications 7 à 11, dans lequel la couche d'émetteur (5) sur le côté revers (RS) est séparée entre un premier modèle de contacts et un deuxième par une gravure masquée, les modèles de contacts (7, 8) étant utilisés comme masques.
